# FASCICULE DE BREVET EUROPEEN

(11) **EP 2 839 489 B1**
(45) Date de publication et mention de la délivrance du brevet: **26.09.2018**
(21) Numéro de dépôt: 13715707.9
(22) Date de dépôt: 15.04.2013
(51) Int. Cl.: H01F 10/00, H01F 41/32, H01F 10/32

(54) **SOURCE DE COURANT POLARISEE EN SPINS**
SPINPOLARISIERTE STROMQUELLE
SPIN-POLARISED CURRENT SOURCE

(30) Priorité: 18.04.2012 FR 1253564
(43) Date de publication de la demande: 25.02.2015
(73) Titulaire: Centre National de la Recherche Scientifique, 75016 Paris (FR); Université de Strasbourg, 67081 Strasbourg cedex (FR)
(72) Inventeur: BOWEN, Martin, 77694 Kehl (DE); WEBER, Wolfgang, 77694 Kehl (DE); JOLY, Loïc, F-67205 Oberhausbergen (FR); BEAUREPAIRE, Eric, 67550 Vendenheim (FR); SCHEURER, Fabrice, 67370 Behlenheim (FR); BOUKARI, Samy, 68180 Horbourg-Wihr (FR); ALOUANI, Mébarek, 67202 Wolfisheim (FR)
(74) Mandataire: Lavoix
(86) Numéro de dépôt international: PCT/EP2013/057804
(87) Numéro de publication internationale: WO 2013/156441

(56) Documents cités:
- US-A1- 2009 011 284
- MIRKO CINCHETTI ET AL: "Determination of spin injection and transport in a ferromagnet/organic semiconductor heterojunction by two-photon photoemission", NATURE MATERIALS, vol. 8, no. 2, 1 février 2009 (2009-02-01) , pages 115-119, XP055040649, ISSN: 1476-1122, DOI: 10.1038/nmat2334
- STEFAN LACH ET AL: "Metal-Organic Hybrid Interface States of A Ferromagnet/Organic Semiconductor Hybrid Junction as Basis For Engineering Spin Injection in Organic Spintronics", ADVANCED FUNCTIONAL MATERIALS, vol. 22, no. 5, 7 mars 2012 (2012-03-07), pages 989-997, XP055040342, ISSN: 1616-301X, DOI: 10.1002/adfm.201102297 cité dans la demande
- CLÉMENT BARRAUD ET AL: "Unravelling the role of the interface for spin injection into organic semiconductors", NATURE PHYSICS, vol. 6, no. 8, 1 août 2010 (2010-08-01), pages 615-620, XP055040088, ISSN: 1745-2473, DOI: 10.1038/nphys1688 cité dans la demande
- S. JAVAID ET AL: "Impact on Interface Spin Polarization of Molecular Bonding to Metallic Surfaces", PHYSICAL REVIEW LETTERS, vol. 105, no. 7, 1 août 2010 (2010-08-01), XP055040658, ISSN: 0031-9007, DOI: 10.1103/PhysRevLett.105.077201

## Description

### DOMAINE TECHNIQUE

La présente demande concerne le domaine technique de l'électronique, plus précisément celui de la spintronique. L'invention concerne notamment un dispositif permettant de filtrer les électrons le traversant, en fonction de l'orientation de leur spin, ainsi qu'un procédé de filtrage.

### ÉTAT DE LA TECHNIQUE ANTÉRIEURE

Les progrès technologiques effectués dans l'industrie des semi-conducteurs ont permis de diminuer fortement les dimensions des dispositifs électroniques, augmentant ainsi leur puissance et leur complexité. Aujourd'hui, la réalisation de ces dispositifs à l'échelle atomique fait face à de nouvelles difficultés, notamment liées aux phénomènes physiques se produisant à cette échelle. Pour continuer à accroître les performances des semi-conducteurs, il est donc nécessaire de développer des dispositifs basés sur de nouveaux concepts.

Un de ces concepts consiste à exploiter la propriété quantique du spin des électrons, dans le but de stocker de l'information. C'est le domaine technique de la spintronique.

Les électrons sont caractérisés par plusieurs valeurs intrinsèques, notamment par leur moment cinétique ou « spin » en anglais. En raison du principe d'incertitude des mesures à l'échelle atomique, la mesure du spin d'un électron n'est possible que selon une seule observable ou direction, et sa valeur peut être positive ou négative. Ces états sont nommés respectivement « spin up » et « spin down ».

Pour exploiter cette caractéristique au niveau industriel, il est nécessaire de développer des dispositifs capables de sélectionner et/ou de lire l'état de polarisation des spins des électrons. Les dispositifs permettant de sélectionner ou de filtrer les électrons en fonction de l'orientation de leur spin, sont nommés dispositifs injecteurs de spins. On cherche à ce qu'ils satisfassent plusieurs des critères ci-dessous pour être industriellement exploitables :
1) permettre de sélectionner ou de filtrer plus de 80% des électrons traversant le dispositif, en fonction de l'état de polarisation de leur spin ;
2) et/ou préserver ce taux de filtrage à des températures de fonctionnement au moins égales ou supérieures à la température de l'azote liquide, de l'ordre de -200°C, ou de préférence à des températures de fonctionnement de dispositifs microélectroniques, c'est-à-dire, dans une plage de température comprise entre -20°C et 300°C;
3) et/ou être simples et économiques à réaliser;
4) et/ou être de dimensions nanométriques ;
5) et/ou permettre d'injecter les électrons filtrés, selon l'orientation de leur spin, dans des milieux favorables à leur propagation, sans modifier l'état de polarisation desdits spins.

Actuellement, plusieurs dispositifs injecteurs de spins sont en cours de développement. Certains injecteurs de spins exploitent l'effet tunnel pour filtrer les électrons. Cet effet est observé lorsque une barrière, dite barrière tunnel, est interposée entre deux éléments conducteurs. Physiquement, la barrière tunnel est un milieu peu favorable à la diffusion des électrons. Ce milieu peut donc être isolant ou semiconducteur.

Les propriétés quantiques, comme par exemple l'orientation en spin d'une particule, se déplaçant entre deux conducteurs par effet tunnel, sont conservées lors de ce transport. Il est alors possible d'utiliser cette propriété pour transporter de l'information entre deux éléments conducteurs ferromagnétiques. L'état de polarisation des électrons, permettant de coder de l'information grâce à l'orientation de l'aimantation d'un élément conducteur ferromagnétique, peut alors être détecté en modulant l'orientation relative de l'aimantation d'un second conducteur ferromagnétique placé de l'autre côté de la barrière tunnel, l'ensemble formant une jonction tunnel magnétique. En plaçant le dispositif dans un état d'aimantation parallèle ou antiparallèle des deux couches ferromagnétiques, il est ainsi possible de mesurer le degré de polarisation de spin du courant traversant le dispositif. Puisque le courant part d'une électrode en direction de l'autre, les fonctions de polarisation en spin de courant et de détection ou de lecture de cette polarisation, sont attribuées à chacune des deux interfaces de la jonction tunnel magnétique, en fonction du signe du courant. On peut alors inverser l'attribution de polarisation et de détection de spin du courant aux interfaces simplement en changeant le signe du courant traversant le dispositif [Fert, Nobel Lectures 2008].

Les capacités de polarisation en spins d'une jonction tunnel magnétique peuvent être décuplées en sélectionnant une barrière tunnel de structure électronique appropriée à celle des électrodes ferromagnétiques adjacentes. Dans ce cas, certaines fonctions d'onde d'électrons de conduction fortement polarisées en spin, au sein de la couche ferromagnétique, traverseront plus facilement la barrière, ce qui aboutit à un courant fortement polarisé en spin (Bowen et al, Physical Review B 73, R140408 (2006)).

Cet effet a par exemple été observé en interposant une couche d'oxyde de magnésium entre deux couches d'alliage de fer (Appl. Phys. Lett. 90, 212507 (2007)). Des mesures à température ambiante ont alors révélé que 85% des électrons traversant les interfaces de ce type dispositif ont leur spin polarisé selon une même direction et un même sens. Malheureusement, ce mécanisme de filtrage des électrons engendre une augmentation conséquente de la résistance électrique du dispositif. A l'échelle submicronique, le dispositif a une valeur de résistance trop importante pour envisager de façon favorable son utilisation dans l'industrie de la microélectronique. Ce type de dispositif ne vérifie donc pas le quatrième critère précédent.

Afin de réduire la valeur de résistance, la barrière tunnel peut être substituée par des matériaux demi-métalliques qui ont la particularité d'être métalliques pour des électrons de spin polarisé selon une direction et un sens donné, et d'être isolants pour des électrons ayant leur spin polarisé selon une même direction et un sens inverse. Ce type de dispositif permet de réaliser un filtrage en spins des électrons de l'ordre de 95% à 99%. Malheureusement, ces mesures ont pu être obtenues uniquement à des températures de l'ordre de -260°C (J. Phys : Condens. Matter 19, 315208 (2007)). De plus, ces dispositifs sont délicats à réaliser en raison de la composition et de la structure complexe des couches demi-métalliques.

Une autre voie de développement porte sur l'utilisation d'une couche organique en tant que barrière tunnel. Les matériaux organiques, du fait de leur faible masse comparée à celle des matériaux inorganiques, offrent l'avantage de faiblement interagir avec l'état de polarisation des électrons de conduction. Ainsi, leurs spins sont bien moins perturbés lorsqu'ils traversent ce type de matériau sur des épaisseurs mesoscopiques (10-1000nm). Il faut cependant réussir à injecter de façon efficace des porteurs de charge polarisés en spin au sein de ces matériaux.

C'est pourquoi des efforts de recherche récents ont porté sur la polarisation de spin de matériaux organiques à l'interface avec une couche métallique ferromagnétique.

De récents travaux ont montré, au moyen d'un alliage ferromagnétique demi-métallique (J. Phys: Condens. Motter 19, 315208 (2007)), le fort potentiel de ce type d'interface en tant que dispositif injecteur de spins. Là encore, les résultats les plus probants ont été obtenus uniquement pour des températures inférieures à -170°C (Nature Physics 6, 615(2010)). Un inconvénient majeur de ce type de dispositif est donc la perte de ses qualités de filtrage lorsque la température augmente. Les mécanismes de filtrage mis en jeu sont actuellement incompris. Il est considéré par la communauté scientifique que cette perte de filtrage est due à des phénomènes extrinsèques, amplifiés lorsque la température du dispositif augmente (Nature Physics 6, 562(2010)). Un fonctionnement dans un environnement électronique industriel n'est donc pas viable. Des travaux théoriques (Javaid et al, Physical Review Letters 105, 077201 (2010)) ont prédit à température nulle (T=-273,15°C) que l'interface entre une couche ferromagnétique de Co et un plan moléculaire de Phthalocyanines de Manganèse pourrait être polarisée en spin, mais cette polarisation, même en retirant le site central de manganèse (on parle alors de H2Pc), n'aurait pas un rendement suffisant, inférieur à 60%, pour être utilisé au niveau industriel de façon concurrentielle. Le même constat peut être dressé à partir d'autres résultats théoriques et expérimentaux sur les propriétés d'interfaces entre phthalocyanines de Fe, Co ou Cu et les métaux ferromagnétiques Co ou encore Fe [Physical Review B 84 224403 (2011) ; Advanced Functional Materials 22, 989 (2012)].

Enfin, il convient de noter que ces forts taux de polarisation n'ont d'intérêt industriel que lorsqu'ils reflètent le courant de conduction électrique en régime diffusif, qui a par définition lieu a l'énergie de Fermi. A d'autres énergies correspondent d'autre mécanismes de transport et de dépolarisation de spin non pertinents pour la réalisation d'une source de courant polarisée en spin.

A ce jour, aucun dispositif injecteur de spins ne peut être qualifié de satisfaisant. L'un des objectifs de la présente demande est de parvenir à un autre dispositif, vérifiant de préférence un ou plusieurs des critères énoncés précédemment, et de proposer un procédé de filtrage permettant de polariser au moins 75% des électrons d'un courant de conduction diffusive d'électrons au niveau de Fermi en fonction de l'orientation de leurs spins.

### EXPOSÉ DE L'INVENTION

La présente demande porte sur un dispositif permettant d'injecter des spins polarisés dans une couche organique, également nommé injecteur de spins polarisés, sur une source de courant polarisée en spins et un dispositif polyvalent tel que défini ci-après. Ces dispositifs vérifient un ou plusieurs des critères précédents, afin d'être exploitables dans le domaine de l'électronique ou de la microélectronique.

Une source de courant polarisée en spins désigne un dispositif permettant de polariser, selon une même direction et un même sens, les moments de spin d'une majorité d'électrons traversant le dispositif. Une source de courant polarisée en spins comporte donc une source de courant, connectée à un dispositif injecteur de spins polarisés, permettant de filtrer les électrons provenant de la source de courant en fonction de leur spin.

Il est proposé un dispositif injecteur de spins polarisés comportant :
- un matériau électriquement conducteur, appelé substrat dont une première face a des propriétés magnétiques ;
- une couche organique comportant une première face en vis-à-vis d'une seconde, la première face comportant au moins en partie un ensemble d'atomes compris sensiblement dans un même plan, et liés entre eux par des liaisons atomiques parallèles ou sensiblement parallèles à la première face du substrat.

La présente invention propose un procédé de filtrage d'électrons permettant d'obtenir une polarisation de spin d'un courant de conduction d'électrons au niveau de Fermi d'au moins 75%, mis en oeuvre avec une source de courant polarisée en spin comportant au moins :
- un dispositif injecteur de spins polarisés, ledit dispositif injecteur de spins polarisés comprenant au moins un substrat électriquement conducteur dont une première face a des propriétés magnétiques et une couche organique comportant une première face, ladite première face de la couche organique comportant au moins en partie un ensemble d'atomes compris sensiblement dans un même plan et liés entre eux par des liaisons atomiques parallèles ou sensiblement parallèles à la première face du substrat et étant en contact avec la première face du substrat de sorte à former une interface de filtrage du dispositif injecteur de spins polarisés ;
- un matériau électriquement conducteur, appelé masse, disposé en regard de la couche organique tel que la couche organique soit disposée entre la masse et le substrat ;
- une source de courant reliée électriquement à la première face du substrat et à la masse ;
le procédé comportant une mise en circulation du courant de conduction d'électrons, par l'intermédiaire de la source de courant, entre la première face du substrat et la masse, la source de courant polarisée en spin étant exposée à une température supérieure à -220°C.

Les atomes de la première face de la couche organique peuvent présenter, soit seuls, soit par combinaison (comme par exemple un ou des dimères), un état paramagnétique.

Au contact avec la première face du substrat, les atomes de la couche organique forment alors une interface, dite interface de filtrage.

L'état paramagnétique d'au moins une partie des atomes de la couche organique peut aussi être induit par transfert de charge à l'interface substrat/couche organique.

Le dispositif injecteur de spins (polarisés), ou dispositif injecteur d'électrons polarisés en spins, permet de filtrer 75% ou plus de 75%, de préférence plus de 85%, des électrons de conductions issus du substrat et traversant l'interface de filtrage ; en fonction de leur état de polarisation de spin, relatif au référentiel de spin imprimé par le magnétisme du substrat ; lorsque sa température est supérieure à -220°C, ou à -20°C, ou à 0°C ou à 150°C ou à 200°C.

Le procédé de filtrage proposé permet donc d'obtenir un courant d'électrons, au niveau de Fermi, polarisé en spin à plus de 75%.

La première face de la couche organique peut être chimiquement adsorbée par la première face du substrat. Dans ce cas, des liaisons chimiques peuvent s'établir entre les espèces atomiques composant la première face du substrat et la première face de la couche organique. Avantageusement, le phénomène d'adsorption chimique peut permettre à la couche organique de former une extension conductrice du substrat, qui est normalement restreinte aux seuls atomes dudit substrat. La polarisation de spin sur les sites organiques ne sera ainsi pas acquise au prix d'une augmentation de résistance du dispositif comme cela peut être le cas pour des jonctions tunnel de type Fe/MgO.

Afin de favoriser les interactions entre lesdites premières faces, leurs plans moléculaires en contact peuvent être complets.

Les liaisons chimiques entre la première face du substrat et la première face de la couche organique peuvent être, de préférence, caractérisées par des orbitales moléculaires magnétiques, et notamment par des orbitales moléculaires paramagnétiques présentant un ordre magnétique collectif, c'est-à-dire un moment paramagnétique caractérisé par un référentiel magnétique unique, figé dans l'espace et le temps, calqué sur celui du substrat. Autrement dit, le magnétisme (diamagnétisme et/ou paramagnétisme) de la première face de la couche organique se couple avec le magnétisme (ferrimagnétisme, et/ou ferromagnétisme, et/ou antiferromagnétisme) de la première face du substrat. Ce phénomène de couplage est préférentiellement dû au recouvrement des liaisons orbitales entre les atomes composant lesdites premières faces.

Au moins deux atomes adjacents au niveau de la première face organique (de la couche organique), peuvent partager une liaison de type pi, parallèle ou sensiblement parallèle à l'interface de filtrage, ou de nuage électronique parallèle ou sensiblement parallèle à l'interface de filtrage, formant un état paramagnétique. Autrement dit, les lobes des orbitales de deux atomes adjacents de la première face de la couche organique, formant une liaison covalente, sont parallèles entre eux, et perpendiculaires ou sensiblement perpendiculaires à la première face du substrat. L'extension spatiale de la densité d'états résultant de la liaison pi (c'est-à-dire le nuage électronique résultant de la liaison) est, quant à elle, de préférence parallèle ou sensiblement parallèle à la première face du substrat. Cette liaison pi forme un état paramagnétique qui peut avantageusement interagir avec le substrat magnétique. Cette interaction est avantageusement augmentée du fait du décalage spatial de ce nuage électronique, décalage inhérent à la nature de cette liaison pi parallèle à la face du substrat, en direction des atomes de la face du substrat.

La première face du substrat possède de préférence un ordre magnétique caractérisé par un ordre à longue portée des moments magnétiques des atomes (ou d'un sous-ensemble d'atomes). Un ordre à longue portée est défini par une distance supérieure aux distances séparant les premiers, ou les seconds, ou les troisièmes atomes voisins, entourant un atome présent au niveau de ladite première face.

La première face du substrat peut être au moins partiellement ou entièrement antiferromagnétique et être caractérisée par une température de Néel, T_{N}, supérieure à la température de l'azote liquide, par exemple supérieure à -220°C, ou bien supérieure à -20°C, ou 0°C ou 150°C ou 300°C. Cet ordre antiferromagnétique peut être alors porté par des sous-réseaux atomiques d'espèces différentes, chaque sous-réseau d'espèces pouvant être ordonné ferromagnétiquement, de sorte que les propriétés de filtrage de l'interface de filtrage soient portées par au moins un de ces sous-réseaux.

De préférence, la température de Néel du substrat est supérieure aux températures de fonctionnement de dispositifs électroniques.

La première face du substrat peut être au moins partiellement ou entièrement ferromagnétique et être caractérisée par une température de Curie, T_{C}, comprise dans les mêmes plages de valeurs que les températures de Néel citées ci-dessus, et notamment supérieure à -220°C.

La première face du substrat peut être au moins partiellement ou entièrement ferrimagnétique de sorte à ce que l'un des sous-réseaux de spins, porté par un sous-réseau de sites atomiques composant le matériau ferrimagnétique, présente des propriétés ferromagnétiques semblables à celles énoncées dans le paragraphe précèdent, de sorte que les propriétés de filtrage de l'interface de filtrage soient portées par un de ces sous-réseaux. Dans ce cas, la première face du substrat peut être également caractérisée par une température de Curie supérieure à -220°C.

La première face du substrat peut comporter une ou plusieurs zones antiferromagnétiques et/ou ferromagnétiques et/ou ferrimagnétiques précédentes.

La température de Néel, comme la température de Curie, désigne la température au-dessus de laquelle un matériau magnétique devient paramagnétique. Au-dessus de cette température, l'énergie thermique est suffisante pour rompre l'ordre magnétique de la première face du substrat.

La première face du substrat peut être composée par, ou comporter, un ou plusieurs métaux ou alliages métalliques, composée par les éléments suivants : cobalt, et/ou nickel, et/ou fer, et/ou un alliage de Fer ou de Cobalt avec des métaux de type 4d ou/et 5d tels que le palladium et/ou le platine, et/ou un ou plusieurs oxydes magnétiques tels que Fe₃O₄ ou TiO₍₂₋ₓ₎.

La couche organique recouvrant la première face du substrat peut être composée, ou comporter, d'éléments électriquement isolants ou semi-conducteurs, de type azote ou carbone ou dimères de carbone et/ou oxygène ou par de la phénanthroline.

Selon un mode de réalisation avantageux, la couche organique peut comporter un dépôt de carbone amorphe. Un tel mode de réalisation facilite notamment la réalisation ultérieure d'une électrode métallique sur la couche organique comportant une interface nette et de bonne qualité grâce à l'utilisation du carbone amorphe dans la réalisation de la couche organique. Prenons le cas d'une électrode de Co destinée à être réalisée sur une couche organique de MnPc. En raison de la faible densité d'atomes typique de l'assemblage atomique qui constitue la molécule de MnPc, le dépôt de Co sur le MnPc peut conduire à l'interdiffusion d'atomes de Co au travers de la molécule de MnPc (par exemple au travers des groupes pyrrole). Ceci pourrait dégrader les propriétés de filtrage en spin de cette interface Co déposé sur MnPc (interface supérieure). Afin de contourner cette difficulté tout en maintenant les propriétés inhérentes à l'invention, on peut, après dépôt de la couche moléculaire de MnPc et avant le dépôt de l'électrode métallique ferromagnétique de Co, déposer du carbone amorphe sur le MnPc. Celui-ci va combler les espaces vides du ou des premiers plans moléculaires de surface de MnPc, afin d'offrir une surface dense pour le dépôt ultérieur de Co, et permettre la formation d'une interface à fort taux de filtrage en spin.

Les propriétés magnétiques de la première face du substrat sont éventuellement adressables via un champ magnétique ou un courant externe.

La première face et la seconde face de la couche organique peuvent être parallèles ou sensiblement parallèles entre elles et/ou séparées d'une distance égale à un plan moléculaire ou à 1nm.

Une source de courant polarisée en spin peut être obtenue à partir d'un dispositif précédent, lorsque :
- un matériau électriquement conducteur, appelé masse, est situé au-dessus et en vis-à-vis de la couche organique ;
- la première face du substrat et la face de la masse la plus proche de la précédente, nommée première face de la masse, sont reliées électriquement à une source de courant, de manière à permettre à un flux d'électrons de conduction de traverser l'interface de filtrage.

De préférence, la masse, ou la première face de la masse, peut être éloignée d'une distance suffisante du substrat pour ne pas perturber les liaisons atomiques se formant ou formées entre le substrat et la couche organique au niveau de l'interface de filtrage. Autrement dit, la première face de la masse peut être écartée de l'interface de filtrage pour limiter ou éviter le recouvrement des fonctions d'onde décrivant les liaisons atomiques, entre les atomes constituant la première face du substrat, et les fonctions d'onde décrivant les liaisons atomiques entre les atomes constituant la première face de la masse. Deux fonctions d'onde se recouvrent lorsqu'une portion de l'extension spatiale de chacune occupe le même espace.

L'intensité électrique appliquée entre la première face du substrat et la première face de la masse, peut être de préférence inférieure à l'intensité de claquage ou l'intensité disruptive, entre lesdites premières faces. Ainsi, une tension électrique entre la première face du substrat et la masse peut être inférieure à une tension de claquage entre ces deux éléments.

La seconde face de la couche organique et la première face de la masse peuvent être séparées d'une distance supérieure ou égale à 1nm.

L'espace entre la seconde face de la couche organique et la première face de la masse peut être comblé par un fluide, par exemple de l'air ou un gaz neutre. Cet espace peut également être comblé par un matériau électriquement isolant ou semiconducteur,
de préférence de type organique, tel que tris(8-hydroxyquinoléine)aluminium(lll)(Alq3), porphyrine, phthalocyanine (Pc), 5,6,11,12-tétraphénylnaphthacène (rubrène), dianhydride pérylène-3,4,9,10-tétracarboxylique (PCTDA), tétracyanoéthylène (TCNE), tétrathiafulvalène (TTF), tétracyanoquinodiméthane (TCNQ), Fe-phénanthroline. Eventuellement, ce matériau peut être de nature identique à la couche organique.

Il est également proposé un dispositif dit polyvalent, comportant deux dispositifs injecteurs de spins polarisés précédents, leurs couches organiques étant maintenues ensemble par l'intermédiaire d'une couche, nommée couche intermédiaire.

Selon un mode de réalisation particulier, la masse peut correspondre à un second substrat électriquement conducteur d'un second dispositif injecteur de spins polarisés, une première face du second substrat pouvant comprendre des propriétés magnétiques, le second dispositif injecteur de spins pouvant comporter en outre une seconde couche organique dont une première face comprend au moins en partie un second ensemble d'atomes compris sensiblement dans un même plan et liés entre eux par des liaisons atomiques parallèles ou sensiblement parallèles à la première face du second substrat et étant en contact avec la première face du second substrat de sorte à former une interface de filtrage du second dispositif injecteur de spins polarisés, la couche organique et la seconde couche organique pouvant être solidarisées l'une à l'autre par l'intermédiaire d'une couche intermédiaire apte à être traversée par le courant de conduction d'électrons, le procédé pouvant comporter en outre une étape de mesure ou de lecture de l'état de polarisation du courant de conduction d'électrons par l'intermédiaire du second dispositif injecteur de spins polarisés.

Le premier dispositif injecteur de spins permet dans ce cas de polariser en spin un flux, ou courant de conduction, d'électrons issu au niveau de Fermi du substrat de ce dispositif et traversant son interface de filtrage.

Le second dispositif injecteur de spins permet dans ce cas de mesurer ou lire l'état de polarisation de ce flux.

La couche intermédiaire peut être de préférence de nature organique et avoir une épaisseur :
- inférieure à 3nm afin de favoriser un transport tunnel élastique des électrons entre les deux dispositifs, de préférence en évitant de perturber ou dégrader les propriétés des deux interfaces de filtrages des deux dispositifs, ou
- égale ou supérieure à 3nm pour favoriser un transport par « hopping » ou par effet diffusif.

Les rôles des deux dispositifs injecteurs de spins, respectivement celui permettant de polariser les spins (ou d'écrire), et celui permettant de lire l'état de polarisation des spins du courant, dépendent de la direction du courant les traversant. Ainsi, ces rôles peuvent être inversés en changeant le sens de propagation du courant dans le dispositif polyvalent. Ainsi, si le courant émane du substrat du deuxième dispositif, alors le premier dispositif effectuera la lecture de la polarisation en spins du courant émanant du second dispositif.

Le second dispositif peut être remplacé par tout élément électrique dont on souhaite mesurer la polarisation de spin du courant le traversant, au moyen d'un premier dispositif injecteur de spin, tant que cet élément électrique ne perturbe pas la fonction de filtrage en spin de l'interface de filtrage du premier dispositif injecteur de spin.

Une orientation de l'aimantation du substrat peut être déterminée telle qu'au moins 75% des électrons traversant de manière perpendiculaire ou sensiblement perpendiculaire l'interface de filtrage du dispositif injecteur de spins polarisés soient polarisés selon un référentiel défini par rapport à l'orientation de l'aimantation du substrat. Cette orientation de l'aimantation du substrat peut permettre de réaliser une polarisation positive (électrons de spin up) ou négative (électrons de spin down).

Il est également proposé un procédé de réalisation d'un dispositif d'injecteur de spins polarisés tel que décrit ci-dessus, comportant les étapes suivantes :
- dépôt sur une première face d'un substrat possédant des propriétés magnétiques, et de préférence de surface plane, d'une couche organique ;
- positionnement de la masse en vis-à-vis de la couche organique à une distante suffisante pour ne pas modifier les propriétés magnétiques du substrat et de la couche organique;
- relier électriquement la première face du substrat et la première face de la masse, respectivement à une première électrode et une seconde électrode d'une même source d'intensité ;
- aligner l'aimantation du substrat afin d'obtenir la direction et le sens de spin du courant souhaités. La présente demande porte également sur un procédé d'utilisation d'un dispositif polyvalent précédent, comportant les étapes suivantes :
- dépôt sur une première face d'un substrat possédant des propriétés magnétiques, et de préférence de surface plane, d'une couche organique ;
- dépôt de la couche organique intermédiaire ;
- dépôt sur la deuxième face de la couche organique d'une seconde couche ferromagnétique ;
- relier électriquement la première face du substrat et la deuxième face de la seconde couche ferromagnétique, respectivement à une première électrode et une seconde électrode d'une même source d'intensité ;
- aligner les orientations d'aimantation du substrat et de la seconde couche ferromagnétique de telle façon à pouvoir réaliser les alignements relatifs parallèle et antiparallèle des deux couches ;
- mesurer la résistance et/ou conductance et/ou impédance du dispositif polyvalent selon lesdites configurations parallèle et antiparallèle d'alignement de l'aimantation du substrat et de la seconde couche ferromagnétique.

Ceci permet de déterminer la polarisation en spin du courant traversant le dispositif polyvalent. Eventuellement inverser la direction du courant afin de d'inverser les rôles d'écriture et lecture des deux interfaces du dispositif polyvalent.

Une source de courant polarisée en spin peut être utilisée selon au moins une étape, consistant à appliquer une intensité électrique par l'intermédiaire de la source de courant, entre la première face du substrat et la première face de la masse du dispositif injecteur de spins, lorsque celui-ci est à une température supérieure à -220°C, ou bien supérieure à -20°C, ou 0°C ou 150°C ou 200°C ou 700°C.

Lorsqu'une intensité électrique est appliquée entre la première face du substrat et la première face de la masse, plus de 75%, de préférence plus de 85%, des électrons traversant l'interface de filtrage ont leur spin polarisé selon une même direction et un même sens correspondant à la direction d'aimantation du substrat. Cette polarisation peut être soit positive (électrons de spin up) ou soit négative (électrons de spin down).

Autrement dit, une source de courant polarisée en spin peut être utilisée ou mise en fonctionnement dans des environnements dans lesquels fonctionnent des dispositifs électroniques.

L'intensité électrique appliquée entre la première face du substrat et la première face de la masse peut varier en fonction de la distance séparant ces deux premières faces, et des éléments disposés entre lesdites faces, de sorte que l'intensité soit inférieure à l'intensité de claquage entre lesdites faces.

### BRÈVE DESCRIPTION DES DESSINS

D'autres détails et caractéristiques de l'invention apparaîtront de la description qui va suivre, faite en regard des figures annexées suivantes. Les parties identiques, similaires ou équivalentes des différentes figures portent les mêmes références de façon à faciliter le passage d'une figure à une autre. Les différentes parties représentées sur les figures ne le sont pas nécessairement selon une échelle uniforme, pour rendre les figures plus lisibles.
La figure 1 représente un dispositif d'injection en spins polarisés 1.
La figure 2 représente une source de courant polarisée en spin 2.
La figure 3 représente un dispositif polyvalent 4.
La figure 4 représente des mesures réalisées, à une température de 25°C, par photoémission polarisée en spin, proche du niveau de Fermi, au niveau de l'interface entre une couche organique et une couche magnétique, présentes au niveau des dispositifs 1 et 2 et 3.

### EXPOSÉ DÉTAILLÉ DE MODES DE RÉALISATION PARTICULIERS

A présent, plusieurs exemples de dispositifs injecteurs de spins polarisés, de sources d'intensité polarisée en spin, de dispositif polyvalent, ainsi que leur procédé de réalisation et d'utilisation vont être décrits.

L'un des objectifs de l'invention est de proposer une source de courant polarisée en spin, permettant de polariser selon une même direction et un même sens, plus de 75%, de préférence plus de 85%, des électrons traversant le dispositif.

La température de fonctionnement du dispositif est de préférence comprise dans les gammes de températures d'utilisation des dispositifs microélectroniques. Celles-ci sont généralement comprises entre -20°C et 150°C. Plus largement, les températures d'utilisation d'une source de courant polarisée en spin peuvent être à température non-nulle, et en particulier pour des raisons applicatives supérieures à la température de l'azote liquide, soit environ -200°C, ou bien supérieures à 200°C pour des applications en milieu extrême.

Autrement dit, la présente demande propose une nouvelle source de courant polarisée en spin, comportant un dispositif d'injecteur de spins polarisés, et exploitable au niveau industriel.

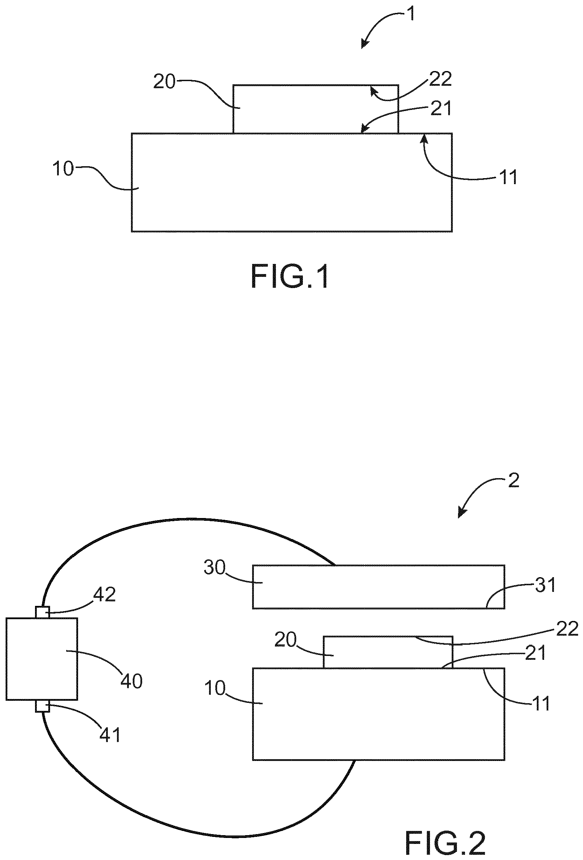

Un dispositif injecteur de spins polarisés 1 comporte un premier matériau électriquement conducteur, appelé substrat 10, dont une première face 11 est en contact avec l'environnement extérieur et possède des propriétés magnétiques de type ferromagnétique et/ou ferrimagnétique et/ou antiferromagnétique (figure 1).

La première face 11 du substrat peut par exemple être à base d'oxyde(s), et/ou de nitrite(s), et/ou de carbure(s), ou à base de cobalt, et/ou de fer, et/ou de nickel et/ou alliage de fer ou de cobalt avec des matériaux de type 4d ou 5d (par exemple comme le FePt et/ou le CoPd).

La première face du substrat 10 est de préférence cristallisée, selon une structure favorisant des états polarisés en spin au niveau de sa surface, pour une gamme d'énergie comprise entre -1eV<E-EF<+1eV, et susceptibles de se coupler électroniquement aux états de la couche organique 20 décrits ci-après.

Lorsque la première face du substrat comporte du cobalt, celle-ci peut avoir une structure cristalline de type cubique face centrée (cfc), l'orientation des plans cristallographiques étant définie par les indices de Miller suivants(001).

La première face 11 est recouverte, au moins en partie, par une couche de matériau organique 20. La couche de matériau organique est délimitée par une première face 21 et une seconde face 22 en vis-à-vis. La distance minimum entre les faces 21 et 22 de la couche organique correspond à l'extension spatiale de la molécule composant la couche, selon une direction perpendiculaire à la surface 21 de la couche organique. Cette distance peut atteindre deux fois cette extension spatiale.

La première face 21 est en contact avec la première face 11 du substrat 10, de sorte à former une interface nommée interface de filtrage.

Les premières faces sont adsorbées au niveau de cette interface. De préférence, la première face 11 du substrat est plane afin de favoriser ou optimiser ce phénomène d'adsorption entre les deux faces 11 et 21.

Avantageusement, afin de favoriser les interactions précédentes entre lesdites premières faces, la molécule organique formant la première face 21 est plane ou sensiblement plane, afin de favoriser sa polarisation par la première face 11 du substrat. Pour la même raison, le plan moléculaire de la première face est de préférence complet.

Les liaisons atomiques entre les atomes composant la première face 21 de la couche organique sont de préférence parallèles ou sensiblement parallèles à la première face 11 du substrat.

La couche organique peut être composée par des atomes de carbone, et/ou d'azote, et/ou d'oxygène, et/ou de bore, et/ou d'hydrogène. Une couche organique 20 peut par exemple être une couche de la famille des porphyrines telle que la phthalocyanine (PC=C₃₂H₁₈N₈). Cette couche peut éventuellement être dopée par des éléments métalliques comme le manganèse (Mn).

A partir de l'un des dispositifs injecteurs de spins 1 précédents, on peut obtenir une source polarisée en spin 2 (figure 2). Pour cela, un second matériau électriquement conducteur 30, appelé masse, est disposé en vis-à-vis de la première face 11 du substrat, la couche organique 20 étant située entre la masse et le substrat.

La masse 30 est de préférence à une distance suffisamment éloignée de ladite première face 11, afin de ne pas modifier ou influencer les propriétés magnétiques de l'interface de filtrage. Autrement dit, la masse est suffisamment écartée de la première face 11 du substrat, afin de ne pas perturber ou empêcher, le couplage des liaisons atomiques entre ladite première face 11 et le plan atomique de la couche organique 20 en contact avec le substrat 10.

Par exemple, la distance séparant la première face 31 de la masse 30, face la plus proche et en vis-à-vis de la première face 11 du substrat, peut être égale ou supérieure à 1nm, ou 3nm, ou 10nm, ou 100nm ou 1000nm. De préférence, la première face 31 est de surface plane et parallèle à la première face du substrat.

Le substrat 10 et la masse 30 sont respectivement connectés aux électrodes 41 et 42 d'une source de courant 40, de sorte que, lorsque la source de courant est mise en fonctionnement, un courant électrique ou un flux d'électrons de conduction traverse le dispositif, perpendiculairement ou sensiblement perpendiculairement à l'interface de filtrage (figure 2).

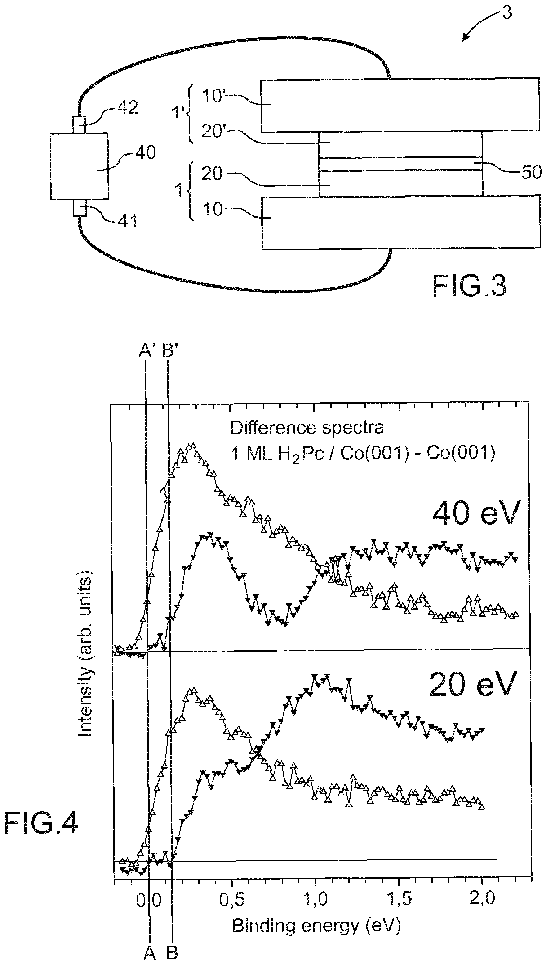

La présente demande porte également sur un dispositif comportant deux dispositifs injecteurs de spins 1 et 1' tels que décrits ci-dessus. Ces dispositifs sont placés en vis-à-vis, plus précisément, leurs couches organiques (20, 20') sont en face-à-face et séparées par une couche intermédiaire 50 (figure 3).

Un tel dispositif est nommé dispositif polyvalent 3 dans la présente demande car, il permet à la fois de :
- polariser en spin un flux d'électrons traversant le premier dispositif injecteur de spins 1 ;
- et de mesurer ou lire l'état de polarisation de ce flux par l'intermédiaire du second dispositif injecteur de spins 1'.

La couche intermédiaire 50 permet avantageusement de transmettre un flux d'électrons entre les deux dispositifs 1 et 1', de préférence, en influençant le moins possible l'état de polarisation des électrons composant ledit flux. Elle peut être de nature organique et avoir une épaisseur définie selon une direction perpendiculaire à l'une des interfaces de filtrage :
- A) inférieure à 3nm, afin de favoriser un transport tunnel élastique des électrons entre les deux dispositifs 1 et 1'; ou
- B) égale ou supérieure à 3nm, pour favoriser un transport par « hopping » ou par effet diffusif entre lesdits dispositifs.

Dans le cas A), le transport sera globalement insensible aux défauts structurels de la couche organique. Dans le cas B), le transport s'effectuera sur des distances plus grandes propices au transport de l'information encodée par le spin des électrons formant le courant électrique.

La couche intermédiaire 50 peut être composée des matériaux mentionnés ci-dessus concernant la couche organique 20, ainsi que les nanotubes de carbone et le graphène. Grâce à la faible dispersion de bande de l'état d'interface permettant le filtrage de spin, le transport électrique qui s'effectue perpendiculairement ou sensiblement perpendiculairement à travers l'interface de filtrage peut alors adopter une direction de propagation différente lors du transport au travers du matériau composant la couche intermédiaire 50, par exemple des nanotubes de carbone ou du graphène.

Afin de lire l'état de polarisation de spin du flux d'électrons, on peut connecter le substrat 10 à une première borne 41 d'une source de courant 40 ; et le substrat 10' à une seconde borne 42 de la même source de courant 40. On peut alors mesurer la résistance (ou conductance, ou impédance) du dispositif polyvalent 3 après avoir établi une orientation parallèle/antiparallèle de l'aimantation des deux couches 10 et 10'.

Si le courant dont on souhaite mesurer la polarisation de spin ne possède pas un référentiel (c'est-à-dire une direction et un sens) établi, on mesurera alors la résistance du dispositif polyvalent 3 tout en faisant varier selon les trois dimensions l'orientation de l'aimantation de la couche ferromagnétique 10' servant de couche de lecture.

La demande concerne aussi un procédé de réalisation d'un dispositif injecteur de spins ci-dessus, comportant au moins une étape de dépôt ou de formation d'une couche organique 20 de phthalocyanine (Pc) sur un substrat 10 de cobalt. La face 11 du substrat peut être cristallisée, les plans de cristallisation définissant une structure cubique de type face centrée (cfc), dont l'orientation est définie par les indices de Miller suivants : (001).

Le dépôt de la couche organique de phthalocyanine peut être réalisé dans une chambre sous vide, dans laquelle la pression est inférieure à 3x10⁻⁸ mbar. La couche organique peut être déposée selon une technique de sublimation ou dite « needle-valve », pour laquelle les molécules en phase vapeur sont introduites au niveau de la face 11 du substrat 10 au moyen d'une buse (Review Scientific Instruments, 82, 033903 (2011); http://dx.doi.org/10.1063/1.3553010).

Le procédé précédent peut être complété par les étapes suivantes, pour obtenir une source de courant polarisée en spin 2 :
- positionnement d'une masse 30 au-dessus et en vis-à-vis de la couche organique 20, à une distance fixe ;
- connexion du substrat 10 à une première borne 41 d'une source de courant 40 ;
- connexion de la masse 30 à une seconde borne 42 de la même source de courant 40.

Il est également possible d'obtenir un dispositif polyvalent 3 tel que décrit précédemment, à partir de deux dispositifs injecteurs de spin, selon les étapes suivantes :
- assembler deux dispositifs injecteurs de spins précédents 1 et 1', par l'intermédiaire d'une couche organique 50 placée entre lesdits dispositifs ;
- connexion du substrat 10 à une première borne 41 d'une source de courant 40 ;
- connexion de la masse 30 à une seconde borne 42 de la même source de courant 40 ;
- aligner les orientations d'aimantation des deux dispositifs de telle façon à pouvoir réaliser les alignements relatifs parallèle et antiparallèle ;
- mesurer la résistance du dispositif polyvalent selon lesdites orientations d'aimantation, afin mesurer ou de lire le degré de polarisation du courant [A. Fert, Nobel Lectures ACS 2008].

Nous allons à présent décrire un procédé d'utilisation d'une source de courant polarisée en spin 2, comportant une couche de H2Pc d'une épaisseur de 0,3nm, déposée sur un substrat de cobalt cristallisé (CFC, (001)). La source de courant polarisée peut être mise en fonctionnement dans un environnement dont la température est supérieure à -20°C, ou 0°C, ou 50°C, ou 100°C, ou 200°C.

Pour cela, la source de courant 40 qui est connectée au substrat 10 ainsi qu'à la masse 30, est mise en marche (figure 2). La tension appliquée est choisie de sorte qu'elle soit inférieure au seuil de tension susceptible de produire un arc électrique entre le substrat et la masse, autrement dit, un claquage électrique. Ce seuil de tension dépend de la distance séparant ces deux éléments, ainsi que des propriétés électriques de l'élément ou des éléments présents entre le substrat et la masse.

Les électrons de conduction, produits par la source de courant 40 et traversant l'interface substrat/couche organique, subissent alors un filtrage selon l'orientation de leur spin. Plus de 75%, de préférence plus de 85%, des électrons traversant ladite interface ou interface de filtrage ont leur spin polarisé selon une même direction et un même sens.

Ce résultat remarquable a été confirmé par des mesures de photoémission polarisées en spin, réalisées à partir d'un dispositif de mesure appelé détecteur de Mott, couplé à une source lumineuse intense dans la gamme des rayons X mous et ultraviolet, en provenance d'une source de lumière de type synchrotron [Solid State Communications 37, 771 (1981) http://dx.doi.org/10.1016/0038-1098(81)91171-6].

La source de lumière synchrotron présente un fort flux lumineux permettant de détecter de faibles quantités de matière et surtout d'ajuster à volonté l'énergie des photons, ce qui permet de faire varier la section efficace, autrement dit la sensibilité de la détection par rapport aux différents éléments présents dans le dispositif. Les énergies choisies doivent rester faibles (<100eV) afin de mettre en évidence les structures caractéristiques polarisées en spin à faible énergie de liaison. En choisissant une énergie de photons de 20eV, on favorise la détection d'atomes légers (carbone, azote) par rapport au cobalt. A 40 eV, les éléments plus lourds, les métaux magnétiques, sont favorisés dans la détection.

Cette source d'énergie dirigée sur l'échantillon comprenant l'interface de filtrage, qui se trouve à la limite entre la couche organique 20 et la couche de cobalt 10 (figure 1). Les mesures sont réalisées à température ambiante, soit à environ 25°C. Un détecteur de type Mott permet de mesurer la polarisation en spin des photoélectrons émis par ladite interface de filtrage. Ce détecteur possède un facteur de Sherman effectif de 0,15 (facteur déterminant la sensibilité de spin de ce type de détecteur). Cette limitation reflète le processus physique de mesure (l'interaction spin orbite induit une asymétrie de la probabilité de rétro diffusion gauche/droite des électrons polarisé en spin à haute énergie sur des atomes lourds. Ce processus de diffusion est appelé « diffusion de Mott »).

L'intensité de photoémission pour chaque canal de spin est alors mesurée sur un ensemble substrat 10 et couche organique 20 en fonction de leur énergie de liaison, c'est-à-dire relative au niveau de Fermi de l'interface 21. Cette intensité est séparément mesurée pour chaque canal de spin et en énergie de liaison pour le seul substrat 10. Grâce à une soustraction par canal de spin de l'intensité provenant uniquement du substrat 10 par rapport à celle de l'ensemble substrat 10 et couche organique 20 (la soustraction tient compte de l'atténuation des photoélectrons issus du substrat 10 au travers de la couche organique 20), on peut alors obtenir la dépendance selon l'énergie de liaison de l'intensité de photoémission de la seule interface 21, qui est composée des électrons formant les liaisons chimiques entre la première face 11 du substrat 10 et la première face 21 de la couche organique 20 Cette dépendance est présentée en figure 4.

Ces mesures montrent de façon surprenante que plus de 80% des électrons liés aux atomes, présents au niveau de l'interface de filtrage, d'énergie proche ou égale au niveau de Fermi (ce qui correspond à la valeur 0 au niveau des abscisses de graphiques présents en figure 4), ont le même état de polarisation en spin. Seuls des électrons polarisés en spin de type up, pour une énergie relative égale à zéro (AA'), sont détectés (figure 4). A l'inverse, pour la même énergie relative, les électrons polarisés de type down, symbolisés par des triangles pleins ne sont pas détectés. Leur signal devient mesurable pour des photons de sonde d'énergie 20eV seulement à partir d'une énergie relative supérieure à E-EF∼=+0,13eV (BB') (figure 4). Ce seuil de détection demeure essentiellement inchangé pour des photons de 40eV. Compte tenu d'erreurs systématiques liées à l'appareillage de détection, nous estimons que le résultat traduit une polarisation de spin proche du/au niveau de Fermi de plus de 80%.

Or, la conductivité électrique d'un matériau dépend directement du nombre d'électrons présents au niveau de l'énergie Fermi. De ce fait, les électrons de conduction, en traversant l'interface de filtrage, percevront une conductivité différente selon que leur polarisation en spin est identique ou non à l'état de polarisation de la population d'électrons la plus importante au niveau de l'énergie de Fermi. Autrement dit, les électrons de conduction peuvent se propager à travers l'interface de filtrage selon deux canaux de résistivités différentes. La résistivité est inversement proportionnelle au nombre d'électrons ayant le même état de polarisation en spin au niveau de l'énergie de Fermi. De la différence de résistivité entre ces deux canaux dépend la qualité de filtrage en spin des électrons de conduction. Les présentes mesures montrent qu'un dispositif injecteur de spins formé par une couche de H₂Pc sur une couche de cobalt cristallisée, permet d'obtenir une interface de filtrage comportant plus de 80% des électrons au niveau de Fermi ayant le même état de polarisation (figure 4). Cette interface forme donc un injecteur de spins polarisés exploitable industriellement.

Autrement dit, un injecteur de spins polarisés industriellement exploitable peut donc être formé à partir d'une couche organique au contact d'une couche possédant des propriétés magnétiques. Pour cela, il est préférable que :
a) les atomes constituant la couche aux propriétés magnétiques 10, qui est en contact avec la couche organique 20, ont leurs électrons au niveau de Fermi ou dans la gamme -1eV<E-EF<+1eV polarisés et ordonnés magnétiquement ;
b) les atomes de la couche organique possèdent un ordre paramagnétique, qui peut être obtenu grâce à des liaisons pi entre eux, ou par toutes liaisons permettant par ailleurs un recouvrement spatial et de même énergie de ces orbitales avec celles des atomes de la surface du substrat 10.

Par hybridation de la molécule suite à son adsorption sur la surface du substrat 10, l'état paramagnétique des atomes de la molécule constituant la couche organique est alors ordonné magnétiquement;
Jusqu'à présent, des valeurs comparables de filtrage (de l'ordre de 80%) étaient uniquement observées avec des dispositifs organiques fonctionnant dans des gammes de températures, inférieures à -220°C. De tels dispositifs ne sont donc pas exploitables dans le domaine de la microélectronique.

A ce jour, il est admis par la communauté scientifique que le taux de filtrage, pour un dispositif injecteur de spins polarisés comportant une interface matériaux ferromagnétiques/matériaux organiques, peut provenir de la présence de défauts structurels à l'interface (Nature Phys. 6, 615 (2010)). Or, ce mécanisme de filtrage se dégrade avec la température. De ce fait, il est considéré comme impossible d'obtenir des taux de filtrage supérieurs à 80% pour de tels dispositifs, fonctionnant à des températures supérieures à -220°C.

De récents travaux de modélisation ont montré que la première couche atomique d'une couche de Pc, dopée en ions manganèse et déposée sur un substrat de cobalt, comporte une densité d'état permettant de polariser seulement 25% des électrons traversant l'interface de filtrage (Physical Review Letters, 105, 077201 (2010)). Ces travaux suggèrent aussi que la modification du site central peut altérer la polarisation de spin. Ces calculs ont été réalisés en considérant que le dispositif fonctionne à la température théorique du zéro absolu, soit environ -273,15°C ! En raison de ces conditions irréalisables, ces résultats ne sont évidemment pas transposables pour des dispositifs réels. Autrement dit, ces travaux ne remettent pas en cause les hypothèses et les observations montrant une dégradation de la qualité du filtrage en spins polarisés lorsque la température du dispositif augmente (Nature Phys. 6, 615 (2010), Nature Physics 6, 562 (2010)).

En outre, il a été observé à partir de dispositifs, cette fois-ci réels, comportant une interface matériaux ferromagnétiques/matériaux organiques, que la performance des matériaux ferromagnétiques dépend directement de l'ordre chimique des atomes composant l'alliage. Cet ordre est très délicat à obtenir expérimentalement, il l'est d'autant plus au niveau industriel. Le modèle théorique ci-dessus ne prend pas en compte cette difficulté de réalisation.

De plus, ce même modèle théorique n'est pas viable pour décrire les propriétés de filtrage en spin de ce type d'interface car, il ne prend pas en compte les phénomènes d'inter-diffusion se produisant entre les couches lors de leur élaboration, phénomène connu comme étant destructeur des propriétés spintroniques d'une interface.

D'autres résultats expérimentaux et théoriques suggèrent eux aussi que le site central de la molécule de Pc peut influencer la polarisation de spin à l'interface avec un matériau ferromagnétique [Physical Review B 84 224403 (2011) ; Advanced Functional Materials 22, 989 (2012)]. Cependant, ces travaux ne suggèrent pas qu'il soit possible, au moyen de ce type interfaces, d'obtenir une polarisation de spin suffisamment forte pour être utilisée au niveau industriel de façon concurrentielle. De plus, dans [Advanced Functional Materials 22, 989 (2012)], les auteurs suggèrent que passer d'une liaison perpendiculaire (FePc, CoPc) à une liaison planaire (CuPc) émanant du substrat de Co pourrait (en prenant en compte le mauvais rapport signal/bruit des résultats expérimentaux) augmenter la polarisation de spin (de quasi 0% à ∼30%) sans toutefois la rendre concurrentielle industriellement. Enfin, l'interface entre Fe cc(001) et CuPc répliquerait, sans apparition d'états d'interface, la polarisation de spin (∼40%) du Fe sous-jacent [Physical Review B 84 224403 (2011)]. Les inventeurs estiment que la relative banalité de ces résultats reflète tant bien la sensibilité des techniques expérimentales utilisées que la qualité/inventivité de l'analyse des résultats obtenus.

Or, de façon surprenante et contrairement à ce qui était jusqu'à présent admis par la communauté scientifique, les inventeurs ont été les premiers à obtenir un dispositif injecteur de spins industriellement exploitable, notamment de très forte polarisation de spin (supérieure à 80%), en déposant une couche de H₂Pc sur une couche de cobalt.

Plus précisément, une couche organique de H2Pc a été déposée sur une couche ferromagnétique de Co, recouvrant un substrat de Cu cristallisé (001).

Plus précisément encore, l'expérience a été répétée avec les même résultats pour d'autres molécules sensiblement bidimensionnelles (MnPc, atomes de carbone liaisonnés pi), ainsi que des molécules tri-dimensionelles de Fe-phenanthroline dont un sous-ensemble d'atomes présentent des liaisons parallèles ou sensiblement parallèles a la surface 11 du substrat. Les résultats ci-dessus montrent que les propriétés de filtrage de ce type d'interface sont :
- intrinsèques au dispositif;
- essentiellement indépendantes du site central au sein de la cage de phthalocyanine ;
- dépendantes de la polarisation d'orbitales électroniques perpendiculaires ou sensiblement perpendiculaires qui liaisonnent les atomes de la couche organique aux atomes composant la couche magnétique.

Il découle de ceci qu'il est préférable que les combinaisons linéaires d'orbitales moléculaires de l'adsorption de la couche organique, sur le substrat magnétique, soit celles d'un état paramagnétique qui se couplera plus aisément au magnétisme du substrat. Pour cela, la couche magnétique comporte de préférence au moins une zone ferromagnétique et/ou antiferromagnétique et/ou ferrimagnétique, en contact avec la couche organique.

Autrement dit, deux atomes de la première face 21 de la couche organique 20, partageant une liaison pi et adsorbés sur le substrat 10, auront leur densité d'état au niveau de Fermi, et seront fortement polarisés en spin tant que les propriétés magnétiques de la première face du substrat sont préservées. Les propriétés de filtrage en spin d'un tel dispositif seront constantes tant que l'énergie thermique sera insuffisante pour rompre l'ordre magnétique de la première face du substrat.

De ce fait, on peut garder les propriétés de filtrage d'un dispositif injecteur de spins tel que décrit ci-dessus, à des températures supérieures à -220°C, ou - 20°C ou 0°C, ou 150°C, ou 200°C, tant que la première face 11 du substrat 10 conserve ses propriétés magnétiques dans la plage de température précédente. La première face 11 du substrat est donc choisie de sorte que sa température de Néel ou de Curie, soit supérieure ou largement supérieure aux températures de fonctionnement du dispositif.

Par exemple, une couche de cobalt d'au moins 3 monocouches (soit environ 0,5nm d'épaisseur) prise en sandwich entre un substrat de cuivre et une couche organique précédente, forme une interface de filtrage (>75%) fonctionnant jusqu'à des températures de l'ordre de 230°C. Cette interface peut ainsi polariser le courant provenant de la couche de cobalt, ou encore permettre la détection de la polarisation de spin d'un courant en direction de la couche de cobalt. Dans le cadre d'un dispositif polyvalent, cette interface peut lire l'amplitude du courant polarisé provenant d'un dispositif électrique apposé sur celle-ci, et en direction de la couche de cobalt, dès lors que ce dispositif ne dégrade pas les propriétés de filtrage de l'interface (voir les considérations énoncées précédemment).

Selon une autre implémentation, un dispositif polyvalent peut être constitué d'un empilement, réalisé sur Si(001), de Cu(70nm)/Ni(5nm), puis d'une couche ferromagnétique 10 de cobalt cfc(001) d'au moins 0,5nm [Phys. Rev. B 60 4087 (1999)], sur laquelle on dépose la couche organique d'interface 20 de H₂Pc de 0,3nm, puis la couche organique H₂Pc intermédiaire 50 de 2,4nm, puis la couche d'interface 20' de H₂Pc de 0,3nm, puis la couche ferromagnétique 10' de cobalt de 100nm, éventuellement durcie magnétiquement par 2,5nm de CoO et éventuellement protégée par une couche d'or. La qualité de l'interface supérieure de filtrage peut être améliorée en effectuant le dépôt de Cobalt à froid (T=-220C). Le filtrage de spin aux deux interfaces engendre une différence relative de résistance du dispositif polyvalent pour les deux orientations parallèle et antiparallèle de relative aimantation des couches ferromagnétiques dépassant 300% (pour une polarisation de spin de chacune des deux interfaces de plus de 80% et ce sans autre filtrage de spin dû à la transmission au travers de la barrière organique), et ce jusqu'à des températures de l'ordre de 230°C, température limitée ici par la stabilité structurelle de l'empilement métallique avant le substrat ferromagnétique 10.

Le tableau ci-dessous donne plusieurs exemples de matériaux de dispositifs injecteurs de spins polarisés permettant d'atteindre un taux de filtrage d'électrons en fonction de leur orientation en spin supérieur ou égal à environ 85 %, c'est-à-dire d'obtenir un courant d'électrons, au niveau de Fermi, polarisé en spin à taux supérieur ou égal à 85 % :

| Substrat 10 | Couche organique 20 |
|---|---|
| Co cfc(001) | MnPc |
| Co cfc(001) | H₂Pc |
| Co cfc(001) | Phenantroline |
| Co cfc(001) | Carbone amorphe |

Pour conclure, la présente demande permet de fabriquer et d'utiliser un dispositif injecteur de spins polarisés, ainsi qu'un dispositif de source de courant polarisée en spins, industriellement exploitables car respectant au moins l'un des critères suivants :
1) l'interface de filtrage du dispositif permet de sélectionner ou de filtrer plus de 75%, de préférence plus de 85%, des électrons de conduction le traversant en fonction de leur spin selon le référentiel imprimé par le substrat magnétique sous-jacent ;
2) ce taux de filtrage en spins polarisés peut être conservé tant que la température de Curie ou de Néel de la première face du substrat est supérieure aux températures de fonctionnement du dispositif ;
3) les matériaux magnétiques ainsi que les matériaux organiques utilisés pour former le dispositif sont abondant ou facilement synthétisables et faciles à assembler selon les techniques couramment utilisées dans l'industrie de l'électronique ;
4) ces techniques de fabrication permettent également de former des dispositifs peu résistifs, notamment lorsqu'ils sont élaborés a des dimensions nanométriques, puisque la couche organique adsorbée sur le substrat métallique devient elle-même métallique ; de ce fait, le dispositif injecteur de spin, comme la source de courant polarisée en spin, peuvent être apparentés d'un point de vue électrique à un conducteur ohmique ;
5) le dispositif injecteur de spins, comme la source de courant polarisée en spins, permettent d'injecter sur de longues distances, dans des matériaux organiques, des électrons de conduction sans modifier leur état de polarisation en spin ; ces deux dispositifs, de par leur utilisation d'une couche organique, sont particulièrement adaptés a l'injection de spins polarisés dans des semi-conducteurs organiques.

## Revendications

1. Procédé de filtrage d'électrons permettant d'obtenir une polarisation de spin d'un courant de conduction d'électrons au niveau de Fermi d'au moins 75%, mis en oeuvre avec une source de courant polarisée en spin (2) comportant au moins :
- un dispositif injecteur de spins polarisés (1), ledit dispositif injecteur de spins polarisés (1) comprenant au moins un substrat (10) électriquement conducteur dont une première face (11) a des propriétés magnétiques et une couche organique (20) comportant une première face (21), ladite première face (21) de la couche organique (20) comportant au moins en partie un ensemble d'atomes compris sensiblement dans un même plan et liés entre eux par des liaisons atomiques parallèles ou sensiblement parallèles à la première face (11) du substrat (10) et étant en contact avec la première face (11) du substrat (10) de sorte à former une interface de filtrage du dispositif injecteur de spins polarisés (1) ;
- un matériau électriquement conducteur, appelé masse (30, 10'), disposé en regard de la couche organique (20) tel que la couche organique (20) soit disposée entre la masse (30, 10') et le substrat (10) ;
- une source de courant (40) reliée électriquement à la première face (11) du substrat (10) et à la masse (30, 10') ;
le procédé comportant une mise en circulation du courant de conduction d'électrons, par l'intermédiaire de la source de courant (40), entre la première face (11) du substrat (10) et la masse (30, 10'), la source de courant polarisée en spin (2) étant exposée à une température supérieure à -220°C.

2. Procédé de filtrage selon la revendication 1, dans lequel la première face (21) de la couche organique (20) est chimiquement adsorbée par la première face (11) du substrat (10).

3. Procédé de filtrage selon la revendication 1, dans lequel des liaisons chimiques entre la première face (11) du substrat (10) et la première face (21) de la couche organique (20) sont **caractérisées par** des orbitales moléculaires paramagnétiques présentant un ordre magnétique collectif.

4. Procédé de filtrage selon l'une des revendications précédentes, dans lequel au moins deux atomes adjacents au niveau de la première face (21) de la couche organique (20) partagent une liaison de type pi, de nuage électronique parallèle ou sensiblement parallèle à l'interface de filtrage, formant un état paramagnétique.

5. Procédé de filtrage selon l'une des revendications précédentes, dans lequel la première face (11) du substrat (10) est au moins partiellement antiferromagnétique et **caractérisée par** une température de Néel supérieure à -220°C.

6. Procédé de filtrage selon l'une des revendications précédentes, dans lequel la première face (11) du substrat (10) est au moins partiellement ferromagnétique ou ferrimagnétique, et **caractérisée par** une température de Curie supérieure à -220°C.

7. Procédé de filtrage selon l'une des revendications précédentes, dans lequel la première face (11) du substrat (10) comporte au moins l'un des éléments suivants : cobalt, nickel, fer, un alliage de fer ou de cobalt avec des métaux de type 4d ou/et 5d, un ou plusieurs oxydes magnétiques.

8. Procédé de filtrage selon l'une des revendications précédentes, dans lequel la couche organique (20) comporte des éléments électriquement isolants ou semi-conducteurs, de type carbone ou dimères de carbone et/ou oxygène, ou de la phénanthroline.

9. Procédé de filtrage selon l'une des revendications précédentes, dans lequel la masse (30) est éloignée d'une distance suffisante du substrat (10) pour ne pas perturber des liaisons atomiques formées entre le substrat (10) et la couche organique (20) au niveau de l'interface de filtrage.

10. Procédé de filtrage selon l'une des revendications précédentes, dans lequel un espace entre une seconde face (22) de la couche organique (20), opposée à la première face (21) de la couche organique (20), et la masse (30) est comblé par un matériau organique comportant au moins l'un des éléments suivants : Alq3, Pc, rubrene, PCTDA, TCNE, TTF, TCNQ.

11. Procédé de filtrage selon l'une des revendications 1 à 8, dans lequel la masse correspond à un second substrat (10') électriquement conducteur d'un second dispositif injecteur de spins polarisés (1'), une première face du second substrat (10') comprenant des propriétés magnétiques, le second dispositif injecteur de spins (1') comportant en outre une seconde couche organique (20') dont une première face comprend au moins en partie un second ensemble d'atomes compris sensiblement dans un même plan et liés entre eux par des liaisons atomiques parallèles ou sensiblement parallèles à la première face du second substrat (10') et étant en contact avec la première face du second substrat (10') de sorte à former une interface de filtrage du second dispositif injecteur de spins polarisés (1'), la couche organique (20) et la seconde couche organique (20') étant solidarisées l'une à l'autre par l'intermédiaire d'une couche intermédiaire (50) apte à être traversée par le courant de conduction d'électrons,
le procédé comportant en outre une étape de mesure ou de lecture de l'état de polarisation du courant de conduction d'électrons par l'intermédiaire du second dispositif injecteur de spins polarisés (1').

12. Procédé de filtrage selon l'une des revendications précédentes, dans lequel une tension électrique entre la première face (11) du substrat (10) et la masse (30, 10') est inférieure à une tension de claquage entre ces deux éléments.

13. Procédé de filtrage selon l'une des revendications précédentes, dans lequel une orientation de l'aimantation du substrat (10) est déterminée telle qu'au moins 75% des électrons traversant de manière perpendiculaire ou sensiblement perpendiculaire l'interface de filtrage du dispositif injecteur de spins polarisés (1) soient polarisés selon un référentiel défini par l'orientation de l'aimantation du substrat (10).

## Patentansprüche

1. Verfahren zum Filtern von Elektronen, welches es erlaubt eine Spin-Polarisation eines Stroms von Leitungselektronen am Fermi-Niveau von mindestens 75% zu erlangen, welcher mittels einer Spin-polarisierter-Strom-Quelle (2) bereitgestellt wird, welche mindestens aufweist:
- eine Polarisierte-Spins-Injektor-Vorrichtung (1), wobei die besagte Polarisierte-Spins-Injektor-Vorrichtung (1) aufweist mindestens ein elektrisch leitendes Substrat (10), von dem eine erste Fläche (11) magnetische Eigenschaften hat, und eine organische Schicht (20), welche eine erste Fläche (21) aufweist, wobei die besagte erste Fläche (21) der organischen Schicht (20) zumindest teilweise eine Menge von Atomen aufweist, die im Wesentlichen in einer gleichen Ebene enthalten sind und zwischen einander mittels Atombindungen, die parallel oder im Wesentlichen parallel zu der ersten Fläche (11) des Substrats (10) sind, verbunden sind, und die in Kontakt mit der ersten Fläche (11) des Substrats (10) sind, um eine Filter-Schnittstelle der Polarisierte-Spins-Injektor-Vorrichtung (1) zu bilden,
- ein elektrisch leitendes Material, welches Masse (30, 10') genannt wird, welches hinsichtlich der organischen Schicht (20) angeordnet ist, sodass die organische Schicht (20) zwischen der Masse (30, 10') und dem Substrat (10) angeordnet ist,
- eine Stromquelle (40), die elektrisch mit der ersten Fläche (11) des Substrats (10) und mit der Masse (30, 10') verbunden ist,
wobei das Verfahren aufweist ein Fließenlassen des Leitungselektronen-Stroms, mittels der Stromquelle (40), zwischen der ersten Fläche (11) des Substrats (10) und der Masse (30, 10'), wobei die Spin-polarisierter-Strom-Quelle (2) einer Temperatur oberhalb von -220°C ausgesetzt ist.

2. Verfahren zum Filtern gemäß Anspruch 1, wobei die erste Fläche (21) der organischen Schicht (20) von der ersten Fläche (11) des Substrats (10) chemisch adsorbiert ist.

3. Verfahren zum Filtern gemäß Anspruch 1, wobei chemische Bindungen zwischen der ersten Fläche (11) des Substrats (10) und der ersten Fläche (21) der organischen Schicht (20) dadurch charakterisiert sind, dass die paramagnetischen Molekülorbitale eine kollektive magnetische Ordnung aufweisen.

4. Verfahren zum Filtern gemäß einem der vorherigen Ansprüche, wobei mindestens zwei benachbarte Atome am Niveau der ersten Fläche (21) der organischen Schicht (20) eine Bindung des Pi-Typs mit einer Elektronenwolke, die parallel oder im Wesentlichen parallel zu der Filter-Schnittstelle ist, teilen, die einen paramagnetischen Zustand bildet.

5. Verfahren zum Filtern gemäß einem der vorherigen Ansprüche, wobei die erste Fläche (11) des Substrats (10) zumindest teilweise antiferromagnetisch ist und durch eine Néel-Temperatur, die oberhalb von -220°C ist, charakterisiert ist.

6. Verfahren zum Filtern gemäß einem der vorherigen Ansprüche, wobei die erste Fläche (11) des Substrats (10) zumindest teilweise ferromagnetisch oder ferrimagnetisch ist und durch eine Curie-Temperatur, oberhalb von -220°C ist, charakterisiert ist.

7. Verfahren zum Filtern gemäß einem der vorherigen Ansprüche, wobei die erste Fläche (11) des Substrats (10) mindestens eines der folgenden Elemente aufweist: Kobalt, Nickel, Eisen, eine Legierung von Eisen oder von Kobalt mit 4d- und/oder 5d-Typ-Metallen, ein oder mehrere magnetische Oxide.

8. Verfahren zum Filtern gemäß einem der vorherigen Ansprüche, wobei die organische Schicht (20) elektrisch isolierende oder Halbleiter-Elemente des Karbon- oder Karbon-Dimere- und/oder Sauerstoff-Typs oder aus dem Phenantrolin aufweist.

9. Verfahren zum Filtern gemäß einem der vorherigen Ansprüche, wobei die Masse (30) eine ausreichende Entfernung von dem Substrat (10) entfernt ist, um Atombindungen, die zwischen dem Substrat (10) und der organischen Schicht (20) am Niveau der Filter-Schnittstelle gebildet sind, nicht zu stören.

10. Verfahren zum Filtern gemäß einem der vorherigen Ansprüche, wobei ein Raum zwischen einer zweiten Fläche (22) der organischen Schicht (20), die der ersten Fläche (21) der organischen Schicht (20) gegenüberliegt, und der Masse (30) mit einem organischen Material gefüllt ist, welches mindestens eines der folgenden Elemente aufweist: Alq3, Pc, Rubren, PCTDA, TCNE, TTF, TCNQ.

11. Verfahren zum Filtern gemäß einem der Ansprüche 1 bis 8, wobei die Masse zu einem elektrisch leitenden zweiten Substrat (10') einer zweiten Polarisierte-Spins-Injektor-Vorrichtung (1') korrespondiert, wobei eine erste Fläche des zweiten Substrats (10') magnetische Eigenschaften aufweist, wobei die zweite Polarisierte-Spins-Injektor-Vorrichtung (1') ferner eine zweite organische Schicht (20') aufweist, von der eine erste Fläche zumindest teilweise eine zweite Menge von Atomen aufweist, welche im Wesentlichen in einer gleichen Ebene enthalten sind und untereinander mittels Atombindungen, die parallel oder im Wesentlichen parallel zu der ersten Fläche des zweiten Substrats (10') sind, verbunden sind, und die in Kontakt mit der ersten Fläche des zweiten Substrats (10') sind, um eine Filter-Schnittstelle der zweiten Polarisierte-Spins-Injektor-Vorrichtung (1') zu bilden, wobei die organische Schicht (20) und die zweite organische Schicht (20') miteinander mittels einer Zwischen-Schicht (50) verbunden sind, die imstande ist, von dem Leitungselektronen-Strom durchflossen zu werden,
wobei das Verfahren ferner aufweist einen Schritt des Messens oder des Lesens des Polarisationszustandes des Leitungselektronen-Stroms mittels der zweiten Polarisierte-Spins-Injektor-Vorrichtung (1').

12. Verfahren zum Filtern gemäß einem der vorherigen Ansprüche, wobei eine elektrische Spannung zwischen der ersten Fläche (11) des Substrats (10) und der Masse (30, 10') geringer ist als eine Durchschlagspannung zwischen diesen beiden Elementen.

13. Verfahren zum Filtern gemäß einem der vorherigen Ansprüche, wobei eine Orientierung der Magnetisierung des Substrats (10) festgelegt ist, sodass mindestens 75% der Elektronen, welche die Filter-Schnittstelle der Polarisierte-Spins-Injektor-Vorrichtung (1) auf senkrechte oder im Wesentlichen senkrechte Weise passieren, gemäß einem Bezugssystem polarisiert werden, welches von der Magnetisierung des Substrats (10) definiert ist.

## Claims

1. Method of filtering electrons to obtain spin-polarisation of an electron conduction current at the Fermi level of at least 75%, used with a spin-polarised current source (2), comprising at least:
- a polarised spin injection device (1), said polarised spin injection device (1) comprising at least one electrically conducting substrate (10) of which a first face (11) has magnetic properties and an organic layer (20) comprising a first face (21), said first face (21) of the organic layer (20) at least partly comprising a set of atoms approximately in the same plane and bonded to each other by atomic bonds parallel to or approximately parallel to the first face (11) of the substrate (10) and being in contact with the first face (11) of the substrate (10) so as to form a filtering interface for the polarised spin injection device (1);
- an electrically conducting material called ground (30, 10'), arranged facing the organic layer (20) such that the organic layer (20) is located between the ground (30, 10') and the substrate (10);
- a current source (40) electrically connected to the first face (11) of the substrate (10) and the ground (30, 10');
the method comprising circulation of the electron conduction current by means of the current source (40), between the first face (11) of the substrate (10) and the ground (30, 10'), the spin-polarised current source (2) being exposed to a temperature higher than -220°C.

2. Filtering method according to claim 1, in which the first face (21) of the organic layer (20) is chemically adsorbed by the first face (11) of the substrate (10).

3. Filtering method according to claim 1, in which chemical bonds between the first face (11) of the substrate (10) and the first face (21) of the organic layer (20) are **characterised by** paramagnetic molecular orbitals with a collective magnetic order.

4. Filtering method according to one of the previous claims, in which at least two adjacent atoms at the first face (21) of the organic layer (20) share a pi type bond, of electron cluster parallel or approximately parallel to the filtering interface forming a paramagnetic state.

5. Filtering method according to one of the previous claims, in which the first face (11) of the substrate (10) is at least partially antiferromagnetic and is **characterised by** a Neel temperature higher than -220°C.

6. Filtering method according to one of the previous claims, in which the first face (11) of the substrate (10) is at least partially ferromagnetic or ferrimagnetic, and is **characterised by** a Curie temperature higher than -220°C.

7. Filtering method according to one of the previous claims, in which the first face (11) of the substrate (10) comprises at least one of the following elements: cobalt, nickel, iron, an iron or cobalt alloy with 4d and/or 5d type metals, one or several magnetic oxides.

8. Filtering method according to one of the previous claims, in which the organic layer (20) comprises electrically insulating or semiconducting elements, of carbon or dimers of carbon and/or oxygen type, or phenanthroline.

9. Filtering method according to one of the previous claims, in which the ground (30) is at a sufficient distance from the substrate (10) to not disturb atomic bonds formed between the substrate (10) and the organic layer (20) at the filtering interface.

10. Filtering method according to one of the previous claims, in which a space between a second face (22) of the organic layer (20), facing the first face (21) of the organic layer (20), and the ground (30) is filled in by an organic material comprising at least one of the following elements: Alq3, Pc, rubrene, PCTDA, TCNE, TTF, TCNQ.

11. Filtering method according to one of claims 1 to 8, in which the ground corresponds to a second electrically conducting substrate (10') of a second polarised spin injection device (1'), a first face of the second substrate (10') including magnetic properties, the second spin injection device (1') also comprising a second organic layer (20') the first face of which at least partly comprises a second set of atoms approximately in the same plane and bonded to each other by atomic bonds parallel to or approximately parallel to the first face of the second substrate (10') and being in contact with the first face of the second substrate (10') so as to form a filtering interface of the second polarised spin injection device (1'), the organic layer (20) and the second organic layer (20') being fixed to each other by means of an intermediate layer (50) through which an electron conduction current can pass,
the method also comprising a step to measure or read the polarisation state of the electron conduction current by means of the second polarised spin injection device (1').

12. Filtering method according to one of the previous claims, in which an electrical voltage between the first face (11) of the substrate (10) and the ground (30, 10') is less than a breakdown voltage between these two elements.

13. Filtering method according to one of the previous claims, in which an orientation of the magnetisation of the substrate (10) is determined such that at least 75% of the electrons passing through the polarised spin injection device (1) filtering interface and perpendicular or approximately perpendicular to it are polarised in a coordinate system defined relative to the orientation of the substrate (10) magnetisation.
